Europäisches Patentamt

European Patent Office

Office européen des brevets

(19)

(11) Publication number: **0 192 142**
**A1**

## EUROPEAN PATENT APPLICATION

(12)

(21) Application number: **86101611.1**

(22) Date of filing: **07.02.86**

(51) Int. Cl.⁴: **H 01 L 29/78**

(30) Priority: **15.02.85 JP 27747/85**

(43) Date of publication of application:
**27.08.86 Bulletin 86/35**

(84) Designated Contracting States:
**DE FR GB**

(71) Applicant: **Kabushiki Kaisha Toshiba**
**72, Horikawa-cho Saiwai-ku**
**Kawasaki-shi Kanagawa-ken 210(JP)**

(72) Inventor: **Monoi, Makoto c/o Patent Division**
**Kabushiki Kaisha Toshiba 1-1 Shibaura 1-chome**
**Minato-ku Tokyo 105(JP)**

(74) Representative: **Henkel, Feiler, Hänzel & Partner**
**Möhlstrasse 37**
**D-8000 München 80(DE)**

(54) **Charge transfer device.**

(57) A transfer channel (13) for transferring charges and a floating diffusion region (33) are formed in a semiconductor substrate. The region (33) receives the charges transferred through the transfer channel (13) and stores them therein. A transfer gates (25, 27) are formed above the transfer channel (13). An output gate electrode (31) is formed above the end portion of the transfer channel (13, 15, 17). The electrode (31) controls the flow of charges from the transfer channel (13, 15, 17) to the floating diffusion region (33). An output section (39) is provided for producing a voltage signal corresponding to the amount of charges stored in the floating diffusion region (33). The output gate electrode (31) is connected to the transfer substrate (11) to keep small the output impedance of a circuit for supplying a fixed potential to the output gate electrode (31). Therefore, the product of a capacitance of the gate electrode (31) AC coupled to ground and the output impedance of that circuit is very small. With the very small impedance, the noise induced into the output signal (VOUT) by the clock signals ($\phi$1, $\phi$2) is damped for a short period of time. The output signal (VOUT) is littled influenced by the noise, and therefore the charge transfer device is operable at a high speed.

F I G. 1

- 1 -

## Charge transfer device

The present invention relates to improvements made to a charge transfer device, and more particularly to improvements in the structure of the output section of a charge transfer device constructed using a charge coupled device.

Charge transfer devices have a variety of applications, including use as delay lines, area photo sensors, and linear sensors. In using charge transfer devices, frequent voltage signals are required for the production of an output signal. It is for this reason that, in fabricating a single chip's charge transfer device, a CCD register for transferring charge packets and a charge to voltage (C/V) converter are usually combined and fabricated on the chip. The C/V converter produces a voltage corresponding to the amount of the signal charges as transferred through the CCD register.

The CCD register is comprised of a semiconductor well of N conductivity type consisting of, for example, regions for blocking reverse charge flow and arranged at predetermined intervals in the well, these blocking regions being of the N conductivity type and having a lower impurity concentration than that of the well, a plurality of transfer electrodes provided on the semiconductor substrate, an output gate electrode for controlling the flow of charge packets into a floating diffusion region to be given later, and a breeder for applying a predetermined voltage to the output gate electrode.

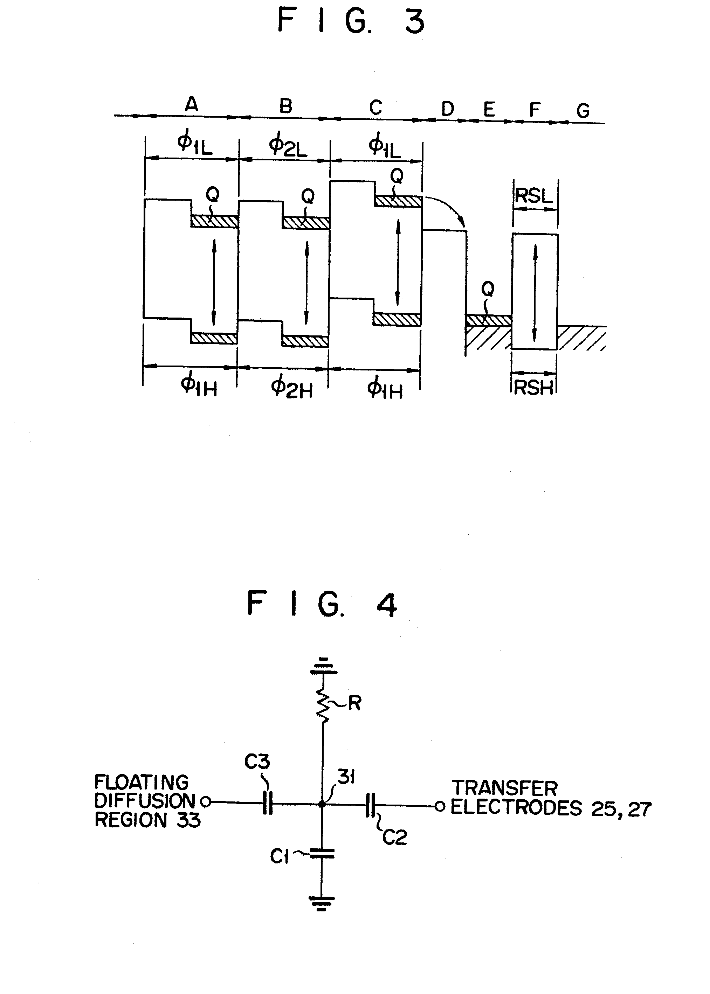

The C/V converter is comprising: a floating diffusion region, formed in contact with the well, which stores the charge packets coming through the CCD register; an output gate electrode for controlling the flow of charges from the CCD register into the floating diffusion region; a breeder for applying a predetermined voltage to the output gate electrode; a charge to voltage converting section (for example, a source follower circuit) for producing a potential corresponding to the amount of charges stored in the floating diffusion region; and a reset electrode. The structure of the charge transfer device of this type is illustrated in Fig. 3a on page 322 of an article by T. Yamada et al. titled "A 3648 ELEMENT CCD LINEAR IMAGE SENSOR", and found in IEDM (1982), pp. 320-323.

In this charge transfer device, two phase clock signals, for example, are applied to the transfer electrodes. The clock signals control the storage and transfer of the signal charges. Under such control, the signal charges are transferred to the floating diffusion region.

Upon application of the clock signals, a coupling capacitance between the portions to which the clock signals have been applied and the output gate electrode, causes the potential at the output gate electrode to change. A change of $\Delta V$ in this potential further changes the potential of the floating diffusion region through a coupling capacitance between the output gate electrode and the floating diffusion region. As a result, noise is induced in the output signal by the clock signals.

As defined by $EXP[-t/(c \cdot R)]$, potential change $\Delta V$ approaches "0" along a curve. In the mathematical expression, c is a capacitance of the ground coupled output gate electrode AC, and R an output impedance of the breeder.   In order to restrict current consumption by the breeder, output impedance R is set at a large value.   Because of the large output impedance, the noise induced is the output signal is damped for a long period of time.   If the charge transfer device thus constructed is operated at a high speed, the period for which the noise is damped increases and exceeds a system tolerable value.   Because of this, the operating speed of the charge transfer device is limited.   Indeed, at the present stage of the technology, it is impossible to operate the device at a satisfactorily high speed.   Although one would think that this defect could be easily overcome through use of a breeder with a small output impedance, this approach is itself inevitably accompanied by an unwanted jump in power consumption.

Accordingly, an object of the present invention is to provide a charge transfer device which is operable at a high speed and in which the noise induced in the output signal by clock signals is negligible.

To achieve this object, there is provided a charge transfer device comprising:

a semiconductor region (13) for transferring charges;

transfer electrodes (25, 27), provided above the semiconductor region (13), for receiving a plurality of clock signals ($\phi 1$, $\phi 2$) to control the transfer and storage of charges in the semiconductor region (13, 15, 17);

a floating diffusion region (33) which receives and stores the charges transferred through the semiconductor region (13, 15, 17);

an output gate electrode (31), formed above the end portion of the semiconductor region (13, 15, 17), for applying a predetermined potential to the end portion of the semiconductor region (13, 15, 17), thereby to control the flow of charges from the semiconductor region (13, 15, 17) to the floating diffusion region (33);

power source means for applying a predetermined potential to the output gate electrode (31); and

an output section (39) for producing a voltage signal corresponding to the amount of charges stored in the floating diffusion region (33),

wherein the product of a capacitance of the output gate electrode (31) AC coupled to ground and the output impedance of the power source means is determined, allowing for a signal period of the voltage signal and a damping period of the noise induced in the output signal by the clock signals, while remaining at a valve below a tolerable valve for guaranteeing normal system operation.

With such an arrangement, the noise induced by the clock signals is damped for a short period of time. Therefore, the output signal is little influenced by the induced noise and, moreover, the device can be operated at a speed required for normal system operation.

This invention can be more fuly understood from the following detailed description when taken in conjunction with the accompanying drawings, in which:

Fig. 1 shows a cross sectional view of the charge transfer device according to a first embodiment of the present invention;

Figs. 2A and 2B show waveforms of clock signals applied to transfer electrodes of the charge transfer device shown in Fig. 1;

Fig. 2C shows a waveform of a reset signal supplied to the reset electrode of the charge transfer device shown in Fig. 1;

Fig. 2D shows a waveform of an exemplary output signal from the device of Fig. 1;

Fig. 3 is a diagram illustrating the distribution of potentials at respective portions in the device of Fig. 1;

Fig. 4 is an equivalent circuit of an electrical circuit existing in the vicinity of the output gate, which circuit is illustrated to explain the induction of noise in the output signal of the device of Fig. 1;

Fig. 5 shows a cross sectional view of a charge transfer device according to a second embodiment of the present invention; and

Fig. 6 shows a cross sectional view of a charge transfer device according to a third embodiment of the present invention.

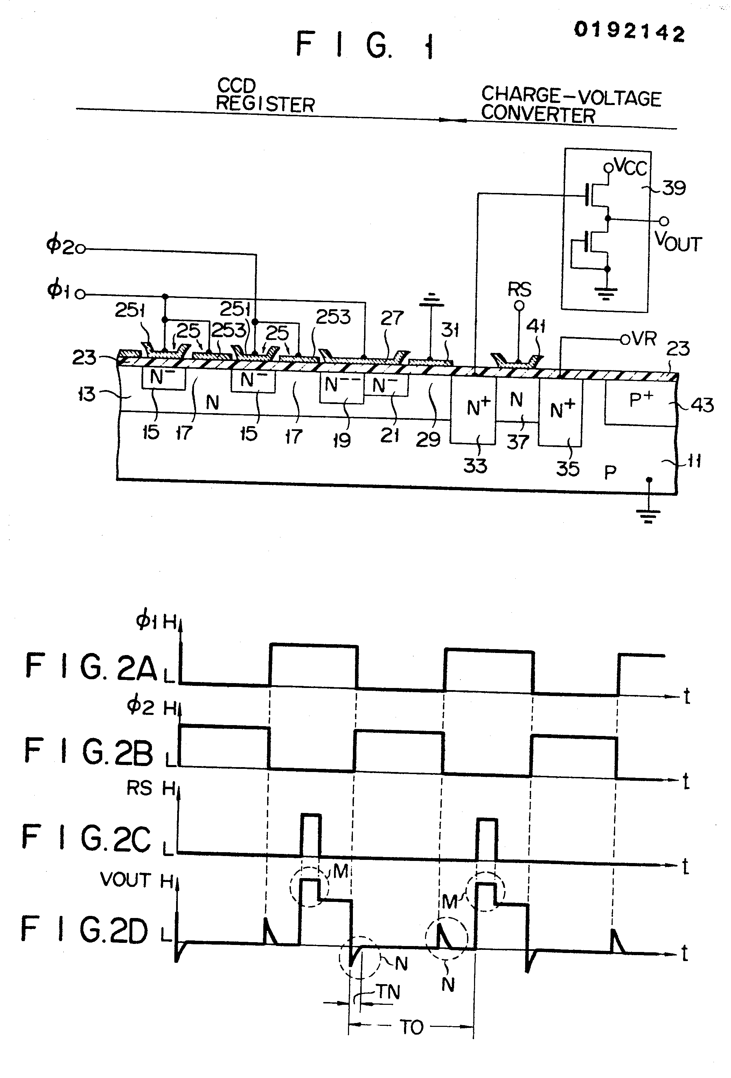

A charge transfer device according to a first embodiment of the present invention will be described with reference to the accompanying drawings. Reference is first made to Fig. 1 for the purpose of explaining the structure of the charge transfer device of the first embodiment.

The charge transfer device is comprised of a CCD register and a charge to voltage converter. The structure of the CCD register is as follows. Transfer channel (well) 13 is formed in the surface region of P type semiconductor substrate 11 with an impurity concentration of approximately $1.5 \times 10^{15}/cm^3$. The channel is for transferring charge packets (signal charges). Transfer channel 13 is designed to have an impurity concentration of $1.5 \times 10^{16}/cm^3$ and a depth of approximately 1 µm. In transfer channel 13, a plurality of reverse charge flow blocking regions 15 are successively arranged at fixed intervals. Each region 15 is of an N type, with impurity concentration and depth specifications of $7 \times 10^{15}/cm^3$, lower than that of transfer channel 13 and 0.5 µm. In Fig. 1, only two reverse charge flow blocking regions 15 are illustrated; however, in actuality, more reverse charge flow blocking regions 15 are provided in that portion of the charge transfer device not illustrated.

One transfer block is formed by one reverse charge flow blocking region 15 and region 17 located between the blocking region 15 and another blocking region 15 closer to floating diffusion region 33. Low concentration regions 15 are provided to block reverse flow of the signal charges. At the final stage of the reverse charge flow blocking regions, region 19 is provided in place of reverse charge flow blocking region 15. The impurity concentration of region 19 is lower than that of transfer channel 13.

Provided adjacent to region 19 is charge storing region 21 whose impurity concentration is also lower than that of transfer channel 13 but higher than that of region 19. In region 19, the impurity concentration is $4 \times 10^{15}/cm^3$ and the depth is 0.5 μm. In region 21, the impurity concentration is $7 \times 10^{15}/cm^3$ and the depth is 0.5 μm. If necessary, these figures can be changed according to, for example, the voltage level of the clock signals.

Insulating film 23 is formed on semiconductor substrate 11. The thickness of insulating film 23 is, for example, 0.1 μm. A plurality of transfer electrodes 25 are formed on insulating film 23. Each transfer electrode 25 consists of barrier electrode 251 and storage electrode 253. Each barrier electrode 251 is formed above a corresponding reverse charge flow blocking region 15, to which it applies potential, thereby prevent charge packets from flowing in the reverse direction. Similarity each storage electrode 253 is formed above and applies ptential to a corresponding region 17, thereby to store charge packets in the corresponding region 17. Final stage transfer electrode 27 is made up of a single electrode formed above reverse charge current blocking region 19 and charge storing region 21. Output gate electrode 31 is provided above N type region 29 (the end portion of transfer channel 13). Region 29 is located between regions 21 and 33. Applied to output gate electrode 31 is voltage (usually, ground potential) applied to semiconductor substrate 11.

The above being the structure of the CCD register, that of the C/V converter will be given next. Floating diffusion region 33 is provided in contact with transfer channel 13. Floating diffusion region 33 receives signal charges transferred through the CCD register and stores the signal charges. Floating diffusion region 33 is of the N type, and has an impurity concentration of $5 \times 10^{19}/cm^3$ and a depth of 1 µm. N type reset drain region 35 is formed in the surface region of semiconductor substrate 11 such that it is spaced from floating diffusion region 33 by a fixed distance. Reset drain region 35 drains the charge packets from floating diffusion region 33, and applies them to an external device (external power source). Drain region 35 has an impurity concentration of $5 \times 10^{19}/cm^3$ and a depth of 1 µm. N type region 37 is formed between regions 33 and 35 such that it is in contact with both of these regions. Region 37 is equal in impurity concentration and depth to transfer channel 13. Region 37 is provided for controlling the transfer of charge packets between regions 33 and 35. Floating diffusion region 33 is connected to the input terminal of source follower circuit 39. Output voltage VOUT of source follower circuit 39 is used as an output voltage of the charge transfer device under discussion. Reset terminal 41 is provided above N type region 37. Reset electrode 41 applies potential to N type region 37 which in turn controls the transfer of charge packets from floating diffusion region 33 to reset drain region 35. P type region 43, which is further formed in semiconductor substrate 11, surrounds the CCD register and the C/V converter, and serves as a channel stopper.

Clock signals $\phi 1$ and $\phi 2$ (Figs. 2A and 2B), which are opposite to one another in polarity, are alternately applied to transfer electrodes 25. Reset signal RS, shown in Fig. 2C, is applied to reset terminal 41, to discharge floating diffusion region 33 in preparation for its initialization. Drain region 35 is connected to a power source (not shown), and kept at fixed positive potential VR.

Fig. 1 illustrates the layout and wiring of the respective portions of the charge transfer device. A light shield film and a passivation film formed on the electrodes are not illustrated so that the electrode might be observed clearly. Similarily, for the sake of simplicity and ease of understanding, the illustrated shapes and configurations of the electrodes, as well as the thickness of the oxide films, differ from those of the actual ones.

The operation of the charge transfer device shown in Fig. 1 will be described with reference to Figs. 2A to 3. In Fig. 3, segment A shows potential at regions 15 and 17 under transfer electrode 25 applied with signal $\phi 1$. Segment B shows potential at regions 15 and 17 under transfer electrode 25 applied with signal $\phi 2$. Segment C shows potential at regions 19 and 21 under transfer electrode 27. Segment D shows potential at region 29, under output gate electrode 31, whose voltage is fixed at ground level, because gate 31 is fixed at ground level. Segment E shows potential at region 37, and segment G shows potential at drain region 35 to be fixed at power voltage VR. In Fig. 3, the lower the portion, the higher potential it has. In terms of potential wells, the lower the well, the deeper it is.

When signal $\phi 1$ is H in level, the signal $\phi 1$-applied potential at regions 15 and 17 under transfer electrodes 25 is high (deep), while the signal $\phi 2$-applied potential at regions 15 and 17 under transfer electrodes 25 is low (shallow). Under this condition, charges flow into regions 15 and 17 under transfer electrodes 25 applied with signal $\phi 1$. When signal $\phi 1$ is L in level, the potential at regions 15 and 17, coupled with second signal $\phi 2$, is high (deep), and charges flow into regions 15 and 17 under transfer electrodes 25 coupled with signal $\phi 2$. As for the potential at regions situated under the same transfer electrode, the region of higher impurity concentration is at a higher potential than that of lower impurity concentration. For this reason, of the regions 15 and 17 which are under the same transfer electrode, the potential at the former is lower (shallower) than that at the latter. Accordingly, the transferred charges are stored in region 17 to block the reverse flow of charges from region 15. As a result, the storage and transfer of the signal charge packet are controlled, and the charge packet is transferred toward floating diffusion region 33 through semiconductor transfer channel 13. The impurity concentration of region 21 is higher than that of region 19. Therefore, the charge packet is stored in region 21.

Output gate electrode 31 is applied with the substrate potential; for example, the ground level potential. The impurity concentration of region 21 is lower than that of region 29. When signal $\phi 1$, applied to the final stage transfer electrode 27, is low in level (for example, ground level), the potential at region 29 is higher (deeper) than that at region 21. The signal charge packet stored in region 21 goes over the potential barrier at output gate electrode 31 and flows into floating diffusion region 33 where it is then stored. The voltage corresponding to the amount of charges stored in floating diffusion region 33 is produced as output signal VOUT, as shown in Fig. 2D, emitted from source follower circuit 39. After output signal VOUT is produced, reset pulse signal RS goes high as shown in Fig. 2C. When signal RS is high in level, the potential at region 37 is high (deep), and the charge packet stored in region 33 is drained into region 35. The drained charge packet is absorbed by the power source (not shown) to conclude the charge initialization of region 33.

By repeating the above sequence of operations, the charge transfer, the charge to voltage conversion, and the charge drainage (the initialization of the floating diffusion region) are performed.

An electrical circuit in the vicinity of output gate electrode 31 can equivalently be expressed as shown in Fig. 4. As shown, output gate electrode 31 is connected to substrate 11 through capacitor C1 AC coupled with ground, to transfer electrodes (the portions supplied with signals $\phi 1$ and $\phi 2$) through coupling capacitor C2, to floating diffusion region 33 through coupling capacitor C3, and to substrate 11 through impedance R. With this connection, when clock signals $\phi 1$ and $\phi 2$ change their level, the potential at output gate electrode 31 changes through coupling capacitor C2. A change $\Delta V$ of the potential at output gate electrode 31 causes the potential at floating diffusion region 33 to change through the coupling capacitor C3 between electrode 31 and region 33. As a result, the induced noise due to the potential change of signals $\phi 1$ and $\phi 2$ is superposed on output signal VOUT, as indicated by N in Fig. 2D.

The induced noise approaches to "0" while being proportional to $EXP[-t/(C1 \cdot R)]$ where t is time. In this embodiment, impedance R is approximately "0" ohm. Therefore, the product of the capacitance AC coupled with ground and the output impedance of the circuit to apply voltage to output gate electrode 31 is extremely small (substantially "0"). This fact indicates that the damping period of the noise induced to output signal VOUT by signals $\phi 1$ and $\phi 2$ is very short. Therefore, the damping period TN is extremely short when compared to the signal period TO ranging from an instant that clock signals $\phi 1$ and $\phi 2$ are level inverted till reset pulse signal RS goes high. Thus, the noise induced to output signal VOUT due to clock signals $\phi 1$ and $\phi 2$ is remarkably reduced. Further, if the system is operated at a high speed, the damping period of the induced noise can be reduced to be shorter than a period tolerable for guaranteeing a normal operation of the system.

In the figure, the portion as indicated by M represents the noise induced by reset signal RS.

If the voltage applied to the output gate electrode of the conventional charge transfer device is simply set at the ground level, the flow of the signal charge packet from the region under the final stage transfer electrode to the floating diffusion region can improperly be controlled. For this reason, it was impossible to apply the substrate potential to the output gate electrode of the charge transfer device with the conventional structure. According to this embodiment, even if the L level (ground level) potential is applied to the final stage transfer electrode 27, the potential at region 29 is higher than that at region 21, because the impurity concentration of region 29 is higher than that of region 21. Therefore, the charges stored in region 21 goes over the potential barrier of the output gate electrode to flow into floating diffusion region 33. In the present embodiment, the charge flow to the floating diffusion region can appropriately be controlled, unlike the case that the output gate electrode of the conventional charge transfer device is simply connected to the ground potential.

In this embodiment, there is no need for the breeder to apply the fixed voltage to output gate electrode 31. This feature simplifies the circuit construction of the charge transfer device, and reduces power consumption. Another feature of this embodiment that the potential at region 37 is lower (shallower) than that of the conventional one, the maximum output voltage of source follower circuit 39 can be made large.

In the embodiment as mentioned above, each transfer electrode 25 consists of electrode 251 and 253. The reason why such structure of electrode 25 was employed is that after the formation of storing electrodes 253, regions 15 are formed using electrodes 253 as a mask. And after that the electrodes 251 are formed. It is evident that the structure of the electrodes according to the present invention is not limited to such, but each electrode may take a single structure. This is true for the final stage transfer electrode 27. Further, the two-phase clock signals $\phi 1$ and $\phi 2$, which are employed in the above-mentioned embodiment, may be replaced by three or more-phase clock signals, if necessary. Furthermore, the conductivity type of the semiconductor substrate and transfer channels 13 may be of the N and P types, respectively. This is correspondingly applied to other embodiments of the present invention to be given later.

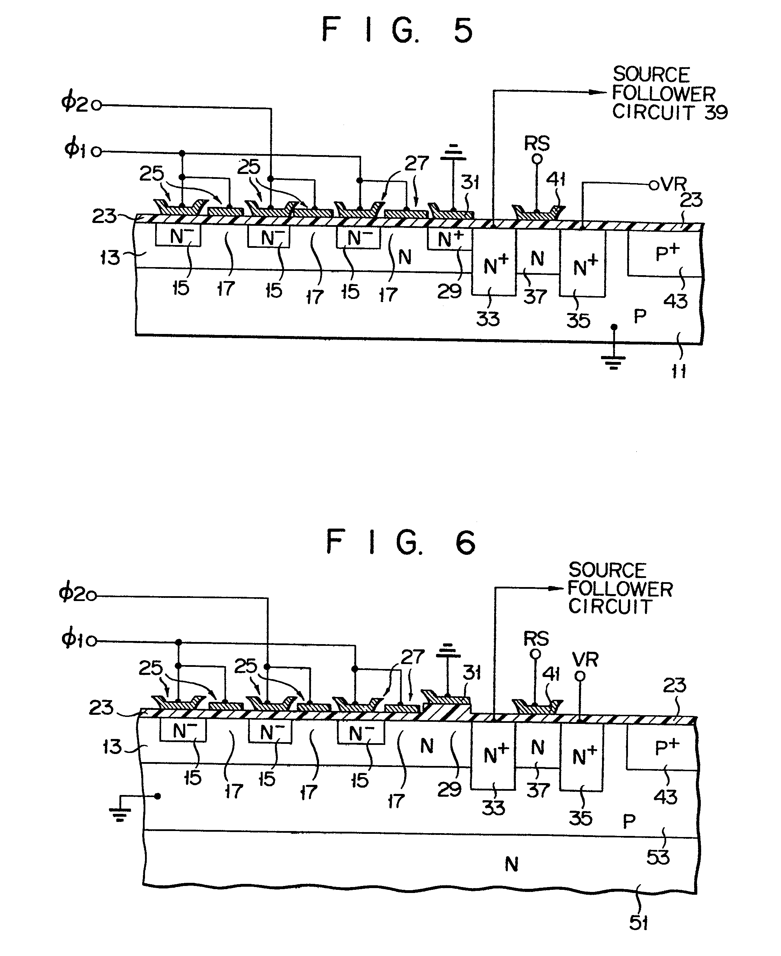

A second embodiment of a charge transfer device according to the present invention will be described referring to Fig. 5. In the figure, like reference symbols are used for designating like portions in Fig. 1. Major differences of the Fig. 5 embodiment from the Fig. 1 embodiment follow. 1) The final stage transfer electrode 27 has the same structure as that of the remaining transfer electrodes 25. 2) The structure of the region located under the final stage transfer electrode 27 is the same as that of the regions under the remaining transfer electrodes 27. 3) The impurity concentration of the region 29 under output gate electrode 31 is higher than that of transfer channel 13, and for example, $1.9 \times 10^{16}/cm^3$ with its depth of approximately 0.5 µm. The substrate potential is applied to output gate electrode 31.

Region 29 has a higher impurity concentration than region 17. When clock signal $\phi 1$ is low in level, the potential at the region 29 under output gate electrode 31 is higher (deeper) than that at the region 17 under region 27. Therefore, the charge packet is allowed to flow into floating diffusion region 33. Also in this embodiment, the substrate potential is applied to output gate electrode 31 as in the case of the first embodiment. Therefore, the output impedance of the circuit to apply potential to region 29 is small. With

- 13 -

0192142

this small impedance, the induced noise by the clock signals is damped for a short period of time. Further, the charge flow to floating diffusion region 33 can appropriately be controlled, unlike the case that the ground potential is applied to the output gate electrode of the conventional charge transfer device.

The above-mentioned embodiments employed the P type substrate. Alternatively, a P well may be provided on an N type substrate with a charge transfer device formed in the P well. Generally, the P well is grounded, and the substrate is set at positive potential. In this case, it is preferable that the output gate electrode is placed at the equal potential to that of the P well, i.e. the ground potential.

A third embodiment of the present invention will be given referring to Fig. 6. In brief, in the third embodiment, a P well is provided in an N type substrate, and a charge transfer device is formed in the P well, as mentioned above. The present invention is applied to the charge transfer device thus arranged. In Fig. 6, like reference symbols are applied to designate like portions in Fig. 1. The structure of the charge transfer device of Fig. 6, whose cross section is illustrated in the same figure, mainly differs from that of Fig. 1 in the following points. 1) P well 53 is formed in N type substrate 51, and the charge transfer device is formed in the P well. 2) Applied to output gate electrode 31 is the potential equal to that of the P well (for example, the ground potential). 3) The structure of the final stage transfer electrode 25 is similar to that of the remaining transfer electrodes 25. The structure of the regions 15 and 17 under the final stage transfer electrode 25 is the same as that of the regions 15 and 17 under the remaining electrodes 25. 5) The thickness of the insulating film 23 under output gate electrode 31 is thicker than the other portion of the film 23. In this embodiment, as referred to in item 5) above, a distance between transfer electrodes 25 and regions 17 is longer than that between electrode 31 and region 29. The thickness of the film depends on the voltage levels of signals $\phi 1$ and $\phi 2$. For example, when the high levels of signals $\phi 1$ and $\phi 2$ is 5 V, the low levels of signals $\phi 1$ and $\phi 2$ is 0 V, insulating film 23 under electrodes 25 and 27 is formed about 0.1 µm, and insulating film 23 under gate electrode 31 is formed about 0.115 µm. In Fig. 6, the impurity concentration of the regions 17 under electrodes 25 is equal to that of the region 29 under gate 31. However, the potential at the region 17 under transfer electrode 25 at the final stage, when clock pulse $\phi 1$ is at the ground level, is lower (shallower) than that at the region 29 under gate electrode 31. The reason for this is that the thickness of insulating film 23 is not uniform. Because of this fact, it is possible to transfer the signal charge packet to floating diffusion region 33. Also in this embodiment, the potential equal to that of P well 53 is applied to the output gate electrode. Therefore, the output impedance of the circuit to apply potential to electrode 31 is small. Consequently, the influence by the induced noise due to the clock pulses can be minimized, as in the first embodiment.

In the above-mentioned embodiments, the structure of the conventional charge transfer device is modified such that even if the ground potential is applied to the output gate electrode, the charge packet can flow into the floating diffusion region. It is evident, however, that the present invention may be embodied in any other form than the specific embodiments as mentioned above, if the following requirements 1) and 2) are satisfied. 1) The transfer channels (13, 15, 17) are so formed that potential under the final stage transfer electrodes (27) is deeper at at least two steps successively in the direction of charge transfer. 2) To allow the charge packet to flow from the transfer channel (13, 15, 17) to the floating diffusion region (33), the potential under the output gate electrode (31) is deeper than that at the final stage in a potential distribution under the final stage transfer electrode (27).

Such an operation can be realized by using the negative voltage for the low level of the signals $\phi 1$ and $\phi 2$ applied to the charge transfer device. However, this approach is unpreferable because the circuit constructions of the device and the power source are complicated.

- 1 -                    0192142

Claims:

1. A charge transfer device comprising:
a semiconductor region (13) for transferring charges;
transfer electrodes (25, 27), provided above said semiconductor region (13), for receiving a plurality of clock signals ($\phi$1, $\phi$2) to control the transfer and storage of charges in said semiconductor region (13, 15, 17);
a floating diffusion region (33) which receives and stores the charges transferred through said semiconductor region (13, 15, 17);
an output gate electrode (31), formed above the end portion of said semiconductor region (13, 15, 17), and for applying a predetermined potential to the end portion of said semiconductor region (13, 15, 17), thereby to control the flow of charges from said semiconductor region (13, 15, 17) to said floating diffusion region (33);
power source means for applying a predetermined potential to said output gate electrode (31); and
an output section (39) for producing a voltage signal corresponding to the amount of charges stored in said floating diffusion region (33),
characterized in that the product of a capacitance of said output gate electrode (31) AC coupled to ground and the output impedance of said power source means is determined, allowing for a signal period of said voltage signal and a damping period of the noise induced to said output signal by said clock signals, and is smaller than a value tolerable for guaranteeing a normal system operation.

2. A charge transfer device according to claim 1, characterized in that said semiconductor region (13, 15, 17) is formed in a semiconductor substrate of the conductivity type different from that of said semiconductor region (13, 15, 17), and said power source means is a means for connecting said output gate electrode (31) to said semiconductor substrate (11).

3. A charge transfer device according to claim 1, characterized in that said semiconductor region (13, 15, 17) is formed in a semiconductor well of the conductivity type different from that of said semiconductor region (13, 15, 17);

said semiconductor well (53) is formed in a semiconductor substrate (51) of the same conductivity type as that of said semiconductor region (13, 15, 17);

said power source means is a means for connecting said output gate electrode (31) to said semiconductor well (53).

4. A charge transfer device according to claim 1, characterized in that said power source means applies ground potential to said output gate electrode (31).

5. A charge transfer device according to claim 1, characterized in that said semiconductor region (13) is so formed that the potential under the final stage transfer electrode (27) is deeper at least two steps successively in the direction of charge transfer, and that the potential under said output gate electrode (31) is deeper than the potential at the final stage in a potential distribution under said final stage transfer electrode (27) according to a potential level of said clock signal supplied to said final stage transfer electrode (27), to control charges in said semiconductor region to go over the potential barrier of said output gate electrode (31) and to flow into said floating diffusion region (33).

6. A charge transfer device according to claim 5, characterized in that said semiconductor region has a first region (19) under said final stage transfer electrode (27), said first region (19) having the same conductivity type as that of said semiconductor region (13) and an impurity concentration lower than that of said semiconductor region (13), and further has, in the charge transfer direction, a second region (21) in contact with said first region (19), said second region (21) having the same conductivity type as that of said first region (19) and an impurity concentration higher than that of said first region (19), but lower than that of said semiconductor region (13), and an impurity concentration at the region (29) under said output gate electrode (31) is substantially equal to that of said semiconductor region (13).

7. A charge transfer device according to claim 5, characterized in that said semiconductor region has a first region (13) under said final stage transfer electrode (27), said first region (15) having the same conductivity type as that of said semiconductor region (13) and a lower impurity concentration than that of said semiconductor region (13), and further has, in the charge transfer direction, a second region (17) in contact with said first region (15), said second region (21) having the same conductivity type as that of said semiconductor region (13) and an impurity concentration substantially equal to that of said semiconductor region (13), and an impurity concentration at the region (29) under said transfer electrode (31) is higher than that of said semiconductor region (13).

8. A charge transfer device according to claim 5, characterized in that said semiconductor region has, under said final stage transfer electrode (27), a first region (19) of an impurity concentration than that of said semiconductor region (13), and further has, in the charge transfer direction, a second region (17) in contact with said first region (15), said second region having an impurity concentration substantially equal to that of said semiconductor region (13), and an impurity concentration of the region (29) under said output gate electrode (31) is substantially equal to that of said semiconductor region (13), and a distance between said transfer electrodes (25, 27) and said semiconductor region (13) is shorter than a distance between said output gate electrode (31) and the surface of said semiconductor region (13).

# F I G. 1

CCD
REGISTER

CHARGE—VOLTAGE
CONVERTER

FIG. 2A

FIG. 2B

FIG. 2C

FIG. 2D

# F I G. 3

# F I G. 4

# F I G. 5

SOURCE
FOLLOWER
CIRCUIT 39

φ2o

φ1o

RS

27

41

oVR

25        25        31        23

23        N⁻        N⁻        N⁻        N⁺        N        N        N⁺        P⁺

13        15   17   15   17   15   17        29        33        37        35        43        P

                                                                                                11

# F I G. 6

SOURCE
FOLLOWER
CIRCUIT

φ2o

φ1o

RS

27        41

VR

25        25        31        23

23        N⁻        N⁻        N⁻        N⁺        N        N        N⁺        P⁺

13        15   17   15   17   15   17        29        33        37        35        43        P

                                                                                                53

                                        N

                                                                                                51

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | PATENTS ABSTRACTS OF JAPAN, vol. 8, no. 95 (E-242) [1532], 2nd May 1984; & JP - A - 59 13 373 (SHARP K.K.) 24-01-1984 | 1,2,5-8 | H 01 L 29/78 |
| A,P | PATENTS ABSTRACTS OF JAPAN, vol. 9, no. 61 (E-303) [1784], 19th March 1985; & JP - A - 59 201 468 (TOSHIBA K.K.) 15-11-1984 | 1,2,4 | |
| A,D | INTERNATIONAL ELECTRON DEVICES MEETING, TECHNICAL DIGEST, 13th-15th December 1982, San Francisco, CA, US, pages 320-323, IEEE, New York, US; T. YAMADA et al.: "A 3648 element CCD linear image sensor" * Figure 3 * | 1-3 | TECHNICAL FIELDS SEARCHED (Int. Cl.4) H 01 L G 11 C |

The present search report has been drawn up for all claims

| Place of search | Date of completion of the search | Examiner |
|---|---|---|
| THE HAGUE | 03-04-1986 | CARDON A. |